# DEMANDE DE BREVET EUROPEEN

(11) **EP 2 182 550 A1**
(43) Date de publication de la demande: **05.05.2010**
(21) Numéro de dépôt: 09306006.9
(22) Date de dépôt: 26.10.2009
(51) Int. Cl.: H01L 23/552, H01L 25/16, H01L 23/498

(54) **Dispositif semi-conducteur avec écran de blindage électromagnétique**

(30) Priorité: 29.10.2008 FR 0857371
(71) Demandeur: STMicroelectronics (Grenoble) SAS, 38000 Grenoble (FR)
(72) Inventeur: Dehos, Bruno, 38000, GRENOBLE (FR); Lagoguez, Bruno, 38410, SAINT MARTIN D'URIAGE (FR)
(74) Mandataire: Zapalowicz, Francis

(57) **Abrégé**

Dispositif semi-conducteur comprenant un substrat (2) présentant une face avant présentant des plots extérieurs (7), au moins une puce de circuits intégrés (4) à l'intérieur du substrat, au moins un composant électronique et/ou électrique (5) à l'intérieur du substrat en arrière de ladite puce, un réseau de connexion électrique (8) reliant sélectivement ladite puce et ledit composant entre eux et/ou auxdits plots de connexion électrique, comprenant en outre au moins un écran (13, 17) comprenant une partie substantiellement parallèle à ladite face frontale (3) et une pluralité de vias de connexion électrique (16, 22) reliant cette partie à une pluralité de plots de connexion électrique de ladite face frontale, au moins ladite puce (4) étant à l'intérieur dudit écran.

## Description

La présente invention concerne le domaine des dispositifs semi-conducteurs et plus particulièrement le domaine de ceux qui comprennent des puces et des composants électroniques et/ou électriques intégrés dans un substrat.

Il a pu être observé que le fonctionnement de certaines puces et/ou de certains composants peuvent être perturbés par des rayonnements électromagnétiques extérieurs. En outre, si certaines puces et/ou certains composants traitent notamment des signaux radiofréquences, ils constituent également des sources de perturbations pour les autres puces ou composants intégrés dans un même substrat.

Le document US 2008/303120 décrit un dispositif semi-conducteur dans lequel le substrat, qui porte une puce, est recouvert, sur une face frontale et sur ses faces latérales, des couches formant un écran.

La présente invention a pour but d'améliorer la protection des dispositifs semi-conducteurs notamment contre les effets des ondes électromagnétiques et en conséquence d'en améliorer le fonctionnement.

La présente invention a également pour but d'intégrer la réalisation d'une telle protection dans les moyens habituels de fabrication des dispositifs.

Selon une variante de réalisation, il est proposé un dispositif semi-conducteur qui comprend un substrat présentant une face avant sur laquelle sont formés des plots extérieurs de connexion électrique, au moins une puce de circuits intégrés installée à l'intérieur du substrat, au moins un composant électronique et/ou électrique installé à l'intérieur du substrat en arrière de ladite puce, ledit substrat comprenant un réseau de connexion électrique reliant sélectivement ladite puce et ledit composant entre eux et/ou auxdits plots de connexion électrique.

Le dispositif semi-conducteur peut comprendre en outre au moins un écran, en une matière conductrice de l'électricité, comprenant une partie substantiellement parallèle à ladite face frontale et une pluralité de vias de connexion électrique reliant cette partie à une pluralité de plots de connexion électrique de ladite face frontale, au moins ladite puce étant à l'intérieur dudit écran et lesdits vias de connexion électrique (15, 21) étant disposés autour et à distance de la périphérie de ladite puce (4) de façon à former des murs.

Ledit écran peut être isolé électriquement par rapport au reste du dispositif.

Ladite partie dudit écran peut comprendre une plaque ou couche.

Le dispositif semi-conducteur peut comprendre un premier écran en au moins une matière conductrice de l'électricité et comprenant une partie s'étendant entre ladite puce et ledit composant et une pluralité de vias de connexion électrique reliant cette partie à une première pluralité de plots de connexion électrique, cette pluralité de vias étant disposée autour de la périphérie de ladite puce ; et un second écran en au moins une matière conductrice de l'électricité et comprenant une partie s'étendant en arrière dudit composant et une pluralité de vias de connexion électrique reliant cette partie à une seconde pluralité de plots de connexion électrique, cette seconde pluralité de vias du second écran étant disposée autour et à distance de la pluralité de vias du premier écran.

Ladite partie du premier écran peut comprendre une plaque ou couche.

Ledit réseau de connexion électrique peut être formé entre le premier écran et le second écran et entre la puce et ladite face frontale.

Ledit second écran peut être formé à la périphérie dudit substrat.

Ladite partie dudit premier écran peut comprendre une plaque ou couche.

Ladite partie dudit second écran peut comprendre une plaque ou couche.

Ladite partie dudit second écran peut être formée sur une face arrière du substrat.

Ledit premier écran et ledit second écran peuvent être isolés électriquement l'un par rapport à l'autre et par rapport au reste du dispositif.

Ledit substrat peut être formé de couches de résine non conductrice de l'électricité ; ladite puce, ledit composant et ledit réseau de connexion électrique étant noyés ou intégrés dans au moins certaines desdites couches de résine.

Selon une variante de réalisation, il est proposé un assemblage qui comprend un dispositif semi-conducteur et une plaque de circuit imprimé, dans lequel les plots extérieurs du dispositif semi-conducteur sont reliés à des plots de la plaque par des billes de connexion électrique, la première pluralité de plots de connexion électrique et la seconde pluralité de plots de connexion électrique du dispositif semi-conducteur étant reliées à un potentiel fixe du circuit imprimé, en particulier une masse.

Dans un autre exemple, il est proposé un équipement radio-fréquence comprenant un dispositif semi-conducteur et/ou un assemblage, dans lequel ladite puce comprend un émetteur et/ou un récepteur radio-fréquence.

Un dispositif semi-conducteur va maintenant être décrit à titre d'exemple non limitatif, illustré par le dessin sur lequel :
- la figure 1 représente une coupe schématique, perpendiculairement à une face frontale, d'un dispositif semi-conducteur ;
- et la figure 2 représente une coupe schématique, parallèlement à la face frontale du dispositif semi-conducteur de la figure 1.

Le dispositif semi-conducteur 1 représenté, substantiellement parallélépipédique, comprend un substrat 2 multicouches qui présente une face frontale ou avant 3, une puce 4 installée dans le substrat 2 et disposée parallèlement à et à distance de la face frontale 3, ainsi que des composants électroniques et/ou électriques additionnels 5 installés dans le substrat 2 en arrière et à distance de la puce 4 et disposés les uns à côté et à distance des autres sur un niveau 6 parallèle à la face frontale 3.

La face frontale 3 du substrat 2 comprend une pluralité de plots frontaux extérieurs métalliques 7 de connexion électrique, par exemple répartis selon une matrice.

Le substrat 2 comprend, à l'intérieur, un réseau 8 de connexion électrique composé de lignes métalliques de connexion électrique 9 parallèles à la face frontale 3 et de vias métalliques de connexion électrique 10 perpendiculaires à cette face, agencés sur différents niveaux et différents endroits afin de relier sélectivement, en fonction des besoins spécifiques de connexion électrique, la puce 4, les composants 5 et des plots 11 pris parmi la pluralité de plots 7 de connexion électrique. A cet effet, la puce 4 est munie, sur sa face tournée vers la face frontale 3 de microbilles métalliques de connexion électrique 12.

Dans un exemple de fabrication et de façon connue en soi, le dispositif semi-conducteur 1 peut être obtenu en réalisant successivement, par dépôt, différentes couches d'une résine non conductrice de l'électricité, sur lesquelles on réalise les différentes lignes de connexion électrique 9 par dépôt métallique et gravure, et dans lesquelles on réalise les vias de connexion électrique 10 dans des trous percés par tout moyen connu, la puce 4 et les composants 5 étant noyés dans les différentes couches de résine. La puce 4 peut être disposée à faible distance de la face frontale 3 du dispositif 1 et les composants 5 peuvent être disposés dans la couche arrière du dispositif 1.

Le dispositif semi-conducteur 1 comprend en outre un premier écran métallique 13, ou écran intérieur, qui comprend une partie 14 formée par une plaque ou couche métallique, qui s'étend parallèlement à la face frontale 3 et qui passe entre et à distance de la puce 4 et des composants 5, et qui comprend une pluralité de vias métalliques 15 de connexion électrique qui sont disposés autour et à distance de la périphérie de la puce 4, perpendiculairement à la face frontale 3. Ces vias 15 sont reliés d'une part au-dessous de la plaque 13 et d'autre part à une première série 16 de plots pris parmi les plots frontaux 7.

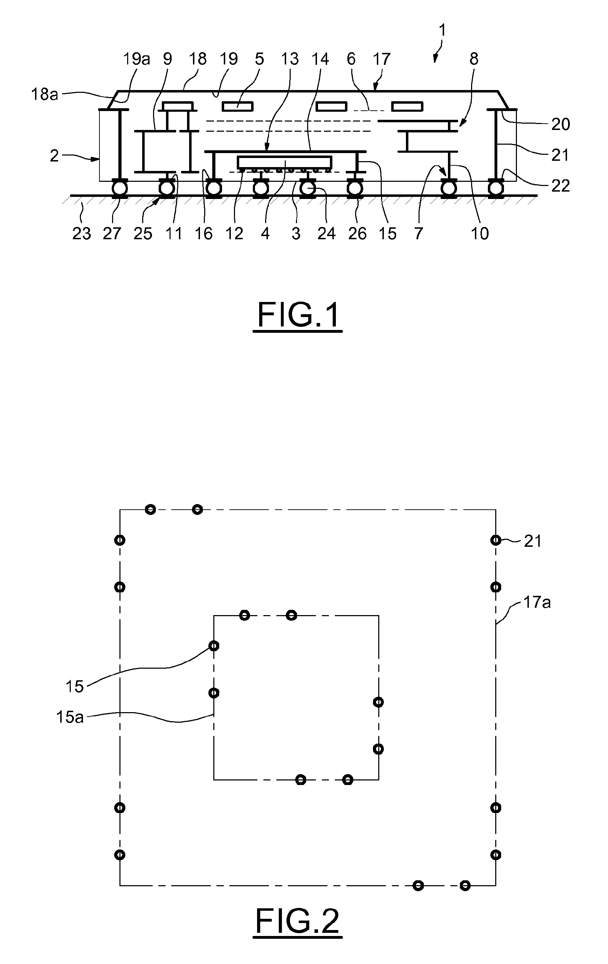

Par exemple, la plaque 14 recouvre à distance la puce 4 et s'étend au-delà des bords de cette dernière et, comme le montre la figure 2, les vias 15 peuvent être répartis sur un carré 15a pour constituer quatre murs, la première série 16 de plots étant aussi répartie sur un carré.

Le dispositif semi-conducteur 1 comprend en outre un second écran métallique 17, ou écran extérieur, qui comprend une partie 18 formée par une couche métallique formée sur une face arrière 19 opposée à la face avant 3 du substrat 2 et se prolongeant par une partie périphérique 18a sur des portions inclinées 19a des côtés du substrat 2. Cette partie périphérique 18a est reliée à un anneau 20 en partie intégré dans le substrat 2. Le second écran 17 comprend également une pluralité de vias métalliques 21 de connexion électrique qui sont disposés dans la périphérie du substrat 2, autour et à distance de la pluralité de vias 15 du premier écran 13 et perpendiculairement à la face frontale 3. Ces vias 21 sont reliés d'une part au-dessous de l'anneau 20 et d'autre part à une seconde série 22 de plots pris parmi les plots frontaux 7.

Par exemple, comme le montre la figure 2, les vias 22 peuvent être répartis sur un carré 17a pour constituer quatre murs, la seconde série 22 de plots étant aussi répartie sur un carré et constituant la série périphérique de la matrice de plots 7.

Les vias 15 et 21 peuvent être respectivement disposés à égales distances, à des distances très proches. Ils peuvent être respectivement reliés aux plots 16 et 22 directement ou par des lignes et vias auxiliaires ménagés dans la partie du substrat 2 proche de sa face frontale 3.

Il est avantageux que le réseau de connexion électrique 8 soit formé entre le premier écran métallique 13 et le second écran métallique 17 et entre la puce 4 et la face frontale 3 et qu'il ne présente ni lignes ni vias entre la puce 4 et la plaque 14 et entre la périphérie de la puce 4 et au moins une grande partie des vias 15 à partir de la plaque 14.

La plaque 14 et les vias 15 du premier écran 13, ainsi que les vias 21 et la couronne 20 du second écran 17, peuvent être intégrés dans la fabrication décrite plus haut, tandis que la couche 18 du second écran 17 peut être obtenue par une dépôt métallique sur la face arrière 19 et les portions 19a du substrat 2, en rejoignant la couronne 20.

Pour réaliser un assemblage, le dispositif 1 peut être monté sur une plaque 23 de circuit imprimé par l'intermédiaire de billes de connexion électrique 24 interposées entre les plots de la matrice de plots 7 de la face frontale 3 et des plots 24 d'une matrice de plots de la plaque 23 de circuits imprimés.

Une première série de plots 26 prise parmi les plots de la matrice de plots 24, reliée à la série de plots 16 du premier écran 13, et une seconde série de plots 27 prise parmi les plots de la matrice de plots 24, reliée à la série de plots 22 du second écran 17, sont reliées à un potentiel commun, par exemple une masse du circuit imprimé de la plaque 23.

Dans une variante, les billes de connexion électrique 24 peuvent être supprimées, les plots de connexion électrique 7 du dispositif 1 étant alors directement en contact avec les plots 25 de la plaque de circuit imprimé 23.

Par sa structure en forme de cuvette métallique enveloppant la puce 4, le premier écran métallique 13, isolé électriquement du reste du dispositif 1, forme une barrière ou une cage de protection électromagnétique, contribuant à isoler la puce 4 vis-à-vis des ondes électromagnétiques pouvant être issues des composants 5 ou de l'extérieur du dispositif 1 et contribuant à isoler les composants 5 et l'extérieur du dispositif 1 vis-à-vis des ondes électromagnétiques pouvant être émises par la puce 4.

Par sa structure en forme de cuvette enveloppant l'ensemble des autres moyens intégrés dans le substrat 2, le second écran métallique 17, isolé électriquement du reste du dispositif 1, forme une barrière ou une cage de protection électromagnétique, contribuant à isoler la puce 4 vis-à-vis des ondes électromagnétiques pouvant être issues de l'extérieur du dispositif 1, contribuant à isoler l'extérieur du dispositif 1 vis-à-vis des ondes électromagnétiques pouvant être émises par la puce 4, contribuant à isoler les composants 5 vis-à-vis des ondes électromagnétiques pouvant être issues de l'extérieur du dispositif 1, et contribuant à isoler l'extérieur du dispositif 1 vis-à-vis des ondes électromagnétiques pouvant être émises par les composants 5.

Dans une variante de réalisation, plusieurs puces 4 peuvent être installées dans le substrat 2. Le premier écran 13 peut alors être disposé de façon à envelopper toutes ces puces.

A titre d'exemples, la puce 4 peut être un émetteur, un récepteur ou un transmetteur radiofréquences, un amplificateur de puissance, un microprocesseur. Les composants additionnels 5 peuvent être des composants passifs tels que des résistances, des condensateurs, des filtres, des commutateurs, ou des mémoires.

Selon un exemple, le dispositif 1 et/ou l'assemblage de ce dispositif 1 sur la plaque 23 peuvent être intégrés dans un équipement radio-fréquence, la puce 4 pouvant comprendre un émetteur et/ou un récepteur radio-fréquence.

## Revendications

1. Dispositif semi-conducteur comprenant un substrat (2) présentant une face frontale ou avant (3) sur laquelle sont formés des plots extérieurs de connexion électrique (7), au moins une puce de circuits intégrés (4) installée à l'intérieur du substrat, au moins un composant électronique et/ou électrique (5) installé à l'intérieur du substrat en arrière de ladite puce, ledit substrat comprenant un réseau de connexion électrique (8) reliant sélectivement ladite puce et ledit composant entre eux et/ou auxdits plots de connexion électrique, dispositif comprenant en outre au moins un écran (13, 17), en une matière conductrice de l'électricité, comprenant une partie (14, 18) substantiellement parallèle à ladite face frontale (3) et une pluralité de vias de connexion électrique (15, 21) reliant cette partie à une pluralité de plots de connexion électrique (16, 22) de ladite face frontale, au moins ladite puce (4) étant à l'intérieur dudit écran et lesdits vias de connexion électrique (15, 21) étant disposés autour et à distance de la périphérie de ladite puce (4) de façon à former des murs.

2. Dispositif selon la revendication 1, dans lequel ledit écran est isolé électriquement par rapport au reste du dispositif.

3. Dispositif selon l'une des revendications 1 et 2, dans lequel ladite partie dudit écran comprend une plaque ou couche.

4. Dispositif selon l'une quelconque des revendications précédentes, comprenant :
un premier écran (13) en au moins une matière conductrice de l'électricité et comprenant une partie (14) s'étendant entre ladite puce et ledit composant et une pluralité de vias de connexion électrique (15) reliant cette partie à une première pluralité de plots de connexion électrique (16), cette pluralité de vias étant disposée autour de la périphérie de ladite puce ;
et un second écran (17) en au moins une matière conductrice de l'électricité et comprenant une partie (18) s'étendant en arrière dudit composant et une pluralité de vias de connexion électrique (21) reliant cette partie à une seconde pluralité de plots de connexion électrique (22), cette pluralité de vias du second écran étant disposée autour et à distance de la pluralité de vias du premier écran.

5. Dispositif selon la revendication 4, dans lequel ladite partie (14) dudit premier écran (13) comprend une plaque ou couche.

6. Dispositif selon l'une des revendications 4 et 5, dans lequel ledit réseau de connexion électrique est formé entre le premier écran et le second écran et entre la puce et ladite face frontale.

7. Dispositif selon l'une quelconque des revendications 4 à 6, dans lequel ledit second écran est formé à la périphérie dudit substrat.

8. Dispositif selon l'une quelconque des revendications 4 à 7, dans lequel ladite partie dudit second écran comprend une plaque ou couche.

9. Dispositif selon l'une quelconque des revendications 4 à 8, dans lequel ladite partie dudit second écran est formée sur une face arrière du substrat.

10. Dispositif selon l'une quelconque des revendications 4 à 9, dans lequel ledit premier écran et ledit second écran sont isolés électriquement l'un par rapport à l'autre et par rapport au reste du dispositif.

11. Dispositif selon l'une quelconque des revendications précédentes, dans lequel ledit substrat est formé de couches de résine non conductrice de l'électricité ; ladite puce, ledit composant et ledit réseau de connexion électrique étant noyés ou intégrés dans au moins certaines desdits couches de résine.

12. Assemblage comprenant un dispositif semi-conducteur selon l'une quelconque des revendications 4 à 10 et une plaque de circuit imprimé (23), dans lequel les plots extérieurs du dispositif semi-conducteur sont reliés à des plots (24) de la plaque par des billes de connexion électrique, la première pluralité de plots de connexion électrique et la seconde pluralité de plots de connexion électrique du dispositif semi-conducteur é+tant reliées à un potentiel fixe du circuit imprimé, en particulier une masse.

13. Equipement radio-fréquence comprenant un dispositif semi-conducteur selon l'une quelconque des revendications 1 à 11 et/ou un assemblage selon la revendication 12, ladite puce comprenant un émetteur et/ou un récepteur radio-fréquence.
